# EUROPEAN PATENT SPECIFICATION

(11) **EP 2 991 212 B1**
(45) Date of publication and mention of the grant of the patent: **04.03.2020**
(21) Application number: 13883694.5
(22) Date of filing: 28.04.2013
(51) Int. Cl.: H02M 3/00, H02M 5/00, H02M 7/00, H03F 1/02

(54) **VOLTAGE ADJUSTING POWER SOURCE AND METHOD FOR CONTROLLING OUTPUT VOLTAGE**
SPANNUNGSANPASSENDE STROMQUELLE UND VERFAHREN ZUR STEUERUNG DER AUSGANGSSPANNUNG
SOURCE D'ALIMENTATION DE RÉGLAGE DE TENSION ET PROCÉDÉ DE COMMANDE DE TENSION DE SORTIE

(43) Date of publication of application: 02.03.2016
(73) Proprietor: Huawei Technologies Co., Ltd., Longgang District Shenzhen, Guangdong 518129 (CN)
(72) Inventor: SU, Yongge, Shenzhen Guangdong 518129 (CN); HUANG, Jinbo, Shenzhen Guangdong 518129 (CN); WANG, Laiqing, Shenzhen Guangdong 518129 (CN)
(74) Representative: Pfenning, Meinig & Partner mbB
(86) International application number: PCT/CN2013/075000
(87) International publication number: WO 2014/176739

(56) References cited:
- EP-A1- 2 493 060
- CN-C- 100 423 424
- JP-B2- 3 261 947
- US-A1- 2006 068 697
- US-A1- 2009 278 609
- US-A1- 2011 095 846
- US-A1- 2012 200 354
- US-A1- 2012 235 737
- US-B2- 6 816 001

## Description

### TECHNICAL FIELD

The present invention relates to the field of electronic technologies, and in particular, to a variable voltage power supply and a method for controlling an output voltage.

### BACKGROUND

An operating principle of a variable voltage power supply is receiving a reference signal, and controlling, according to the reference signal, the power supply to output a most appropriate voltage which is higher than and closest to the reference signal. This ensures that the variable voltage power supply is working in a nearly saturated state while outputting a linear voltage.

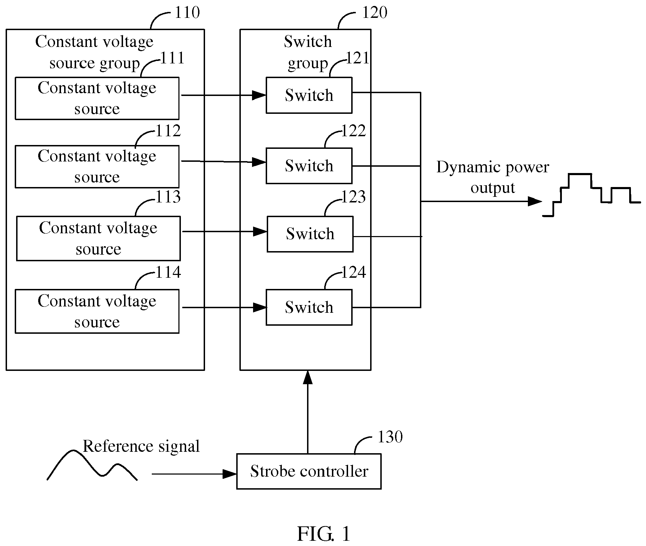

FIG. 1 is a schematic structural diagram of a variable voltage power supply in the prior art. An existing variable voltage power supply includes a constant voltage source group 110, where the constant voltage source group 110 includes multiple constant voltage sources. Each constant voltage source is set with a different voltage level, and each constant voltage source corresponds to one switch in a switch group 120 and a strobe controller 130 connected to the switch group. The strobe controller 130 is configured to select, according to a strength of a reference signal and based on a cycle, a switch corresponding to a most appropriate constant voltage source to close, so as to output a most appropriate voltage. The cycle length is determined beforehand by the strobe controller 130 according to a broadband of the reference signal, a quantity of constant voltage sources, and setup time of the constant voltage sources.

Although the existing variable voltage power supply can output a voltage dynamically, there is a relatively big error between the output voltage and the reference signal when the costs and decrease a volume of the variable voltage power supply. As a result, an accuracy of an output level of the constant power supplies is limited, and therefore the variable voltage power supply cannot accurately output a voltage closest to the reference signal, thereby causing a big tracing error.

EP2493060A discloses a device for converting an input signal having a given input voltage (Vbat) value (Vbat) into an output signal having an output voltage (Vout) (Vout) different from the input voltage (Vbat).

US2012/235737A discloses a power amplifier system includes a power amplifier configured to amplify a radio frequency (RF) signal of a first frequency and an envelope tracker configured to control a supply voltage of the power amplifier using an envelope of the RF signal.

US2012/200354A discloses a method of calibrating an envelope tracker having an envelope shaping table generated at a desired gain compression of a power amplifier is provided. The method includes generating a supply voltage for the power amplifier using the envelope tracker.

### SUMMARY

In view of the above, the present invention provides a variable voltage power supply and a method, as defined in the appended independent claims, for controlling an output voltage, which can accurately output a voltage closest to a reference signal, thereby decreasing a tracing error.

In a first aspect, the present invention provides a variable voltage power supply, where the variable voltage power supply includes a controller, a variable voltage source group, and a switch group, where:
the variable voltage source group includes at least two variable voltage sources and the variable voltage sources group is configured to supply a voltage;
the switch group includes at least two switches, where each switch connects to one variable voltage source, and the switch group is configured to control whether the variable voltage sources output a voltage; and
the controller connects to each of the variable voltage sources and the switch group, and is configured to determine an output voltage required for the variable voltage source group, set a variable voltage source which outputs the required output voltage in the variable voltage group, and control the switch group, so as to control the variable voltage source which is set to output the required output voltage to output a voltage.

In a first possible implementation manner of the first aspect, the controller is specifically configured to: receive a reference signal in a first cycle, determine, according to a strength of the reference signal in a second cycle, an output voltage required for the variable voltage source group in the second cycle, set a variable voltage source which outputs the required output voltage, and control, in the second cycle, a switch corresponding to the variable voltage source which outputs the required output voltage to close.

With reference to the first possible implementation manner of the first aspect, in a second possible implementation manner, the second cycle is any one cycle after the first cycle.

With reference to the first possible implementation manner of the first aspect or the second possible implementation manner of the first aspect, in a third possible implementation manner, the setting a variable voltage source which outputs the required output voltage is specifically as follows: if the output voltage required for the variable voltage source group in the second cycle equals an output voltage of the variable voltage source group in an adjacent cycle before the second cycle, setting a variable voltage source which outputs a voltage in the adjacent cycle before the second cycle to continue outputting the required output voltage in the second cycle.

With reference to the first possible implementation manner of the first aspect or the second possible implementation manner of the first aspect, in a fourth possible implementation manner, the setting a variable voltage source which outputs the required output voltage is specifically as follows: if the output voltage required for the variable voltage source group in the second cycle differs from an output voltage of the variable voltage source group in an adjacent cycle before the second cycle, setting a variable voltage source which does not output a voltage in the adjacent cycle before the second cycle to output the required output voltage in the second cycle.

With reference to the first aspect, or the first possible implementation manner of the first aspect, or the second possible implementation manner of the first aspect, or the third possible implementation manner of the first aspect, or the fourth possible implementation manner of the first aspect, in a fifth possible implementation manner, the controller is further configured to receive voltage feedback signals of the variable voltage sources, so as to adjust a pulse width modulation signal duty cycle of the variable voltage source group according to the voltage feedback signals.

With reference to the first aspect, or the first possible implementation manner of the first aspect, or the second possible implementation manner of the first aspect, or the third possible implementation manner of the first aspect, or the fourth possible implementation manner of the first aspect, or the fifth possible implementation manner of the first aspect, in a sixth possible implementation manner, the controller sets, by using a pulse width modulation signal, the variable voltage source which outputs the required output voltage.

In a second aspect, the present invention provides a method for controlling an output voltage, where the method includes:
receiving a reference signal;
determining, in a first cycle, according to a strength of the reference signal in a second cycle, an output voltage required for a variable voltage source group in the second cycle, where the variable voltage source group includes at least two variable voltage sources, and each variable voltage source corresponds to one switch; and
setting a variable voltage source which outputs the required output voltage in the second cycle; and
controlling, in the second cycle, a switch corresponding to the variable voltage source which outputs the required output voltage to close.

In a first possible implementation manner of the second aspect, the second cycle is any one cycle after the first cycle.

With reference to the second aspect or the first possible implementation manner of the second aspect, in a second possible implementation manner, the setting a variable voltage source which outputs the required output voltage in the second cycle is specifically as follows: if the output voltage required for the variable voltage source group in the second cycle equals an output voltage of the variable voltage source group in an adjacent cycle before the second cycle, setting a variable voltage source which outputs a voltage in the adjacent cycle before the second cycle to continue outputting the required output voltage in the second cycle.

With reference to the second aspect or the first possible implementation manner of the second aspect, in a third possible implementation manner, the setting a variable voltage source which outputs the required output voltage in the second cycle is specifically: if the output voltage required for the variable voltage source group in the second cycle differs from an output voltage of the variable voltage source group in an adjacent cycle before the second cycle, setting a variable voltage source which does not output a voltage in the adjacent cycle before the second cycle to output the required output voltage in the second cycle.

With reference to the second aspect, or the first possible implementation manner of the second aspect, or the second possible implementation manner of the second aspect, or the third possible implementation manner of the second aspect, in a fourth possible implementation manner, the method further includes: receiving voltage feedback signals of the variable voltage sources, where the voltage feedback signals include a value of an actual voltage outputted by the variable voltage source group, so as to adjust a pulse width modulation signal duty cycle of the variable voltage source group according to the voltage feedback signals.

With reference to the second aspect, or the first possible implementation manner of the second aspect, or the second possible implementation manner of the second aspect, or the third possible implementation manner of the second aspect, or the fourth possible implementation manner of the second aspect, in a fifth possible implementation manner, the variable voltage source which outputs the required output voltage is set by using a pulse width modulation signal.

According to the foregoing solutions, by applying variable voltage sources in a variable voltage power supply, a controller can determine, in a first cycle, according to a strength of a reference signal in a second cycle, an output voltage required in the second cycle, set a variable voltage source which outputs the required output voltage, and control, in the second cycle, a switch corresponding to the variable voltage source which is set to output the required output voltage to close, so that a corresponding variable voltage source in the variable voltage source group outputs a voltage closest to the reference signal in the second cycle, thereby decreasing a tracing error.

### BRIEF DESCRIPTION OF DRAWINGS

FIG. 1 is a schematic structural diagram of a variable voltage power supply in the prior art;
FIG. 2 is a schematic structural diagram of a variable voltage power supply according to a first embodiment of the present invention;
FIG. 3 is a schematic structural diagram of a variable voltage power supply according to a second embodiment of the present invention;
FIG. 4 is a schematic structural diagram of another variable voltage power supply according to a second embodiment of the present invention; and
FIG. 5 is a flowchart of a method for controlling an output voltage according to a fourth embodiment of the present invention.

### DESCRIPTION OF EMBODIMENTS

To make the objectives, technical solutions, and advantages of the present invention more clearly, the following further describes the present invention in detail with reference to the accompanying drawings. Apparently, the described embodiments are merely a part rather than all of the embodiments of the present invention. All other embodiments obtained by a person of ordinary skill in the art based on the embodiments of the present invention without creative efforts shall fall within the protection scope of the present invention.

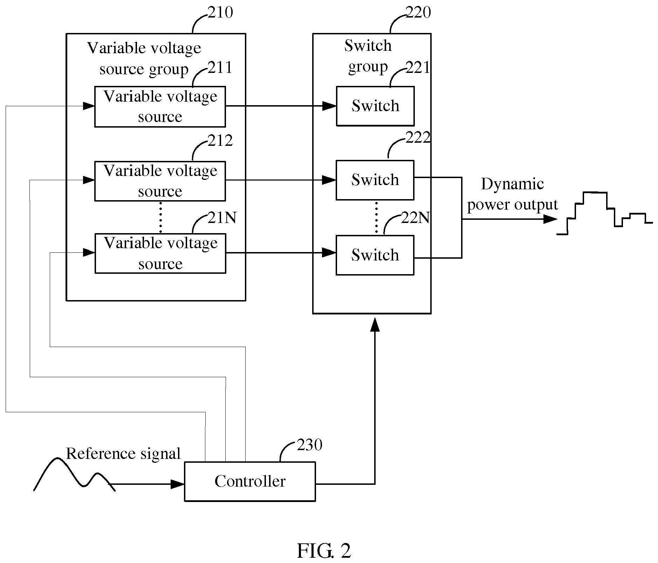

The following describes a variable voltage power supply provided in a first embodiment of the present invention in detail by using FIG. 2 as an example. FIG. 2 is a schematic structural diagram of a variable voltage power supply according to the first embodiment of the present invention. As shown in FIG. 2, the variable voltage power supply includes: a variable voltage source group 210, a switch group 220, and a controller 230.

The variable voltage source group 210 includes at least two variable power supplies, where the variable voltage sources are configured to supply a voltage. As shown in FIG. 2, the variable voltage source group includes a variable power supply 211, a variable power supply 212, and may also include other variable power supplies sequenced to a variable power supply 21N, where the number of places of N is not limited.

The switch group 220 includes at least two switches, where each switch connects to one variable voltage source and the switch group is configured to control whether the variable voltage sources output a voltage. As shown in FIG. 2, the switch group includes a switch 221, a variable power supply 222, and may also include other switches sequenced to a switch 21N, where the number of places of N is not limited.

The controller 230 connects to each of the variable voltage sources and the switch group 220, and is configured to determine an output voltage required for the variable voltage group 210, set a variable voltage source which outputs the required output voltage in the variable voltage group 210, and control the switch group 220, so as to control the variable voltage source which is set to output the required output voltage to output a voltage.

By using the variable voltage power supply provided in the first embodiment of the present invention, by applying variable voltage sources in the variable voltage power supply, a controller can determine an output voltage required for a variable voltage source group, set a variable voltage source which outputs the required output voltage, and control a switch corresponding to the variable voltage source which is set to output the required output voltage to close, so that a corresponding variable voltage source in the variable voltage source group outputs a voltage closest to a reference signal, thereby decreasing a tracing error.

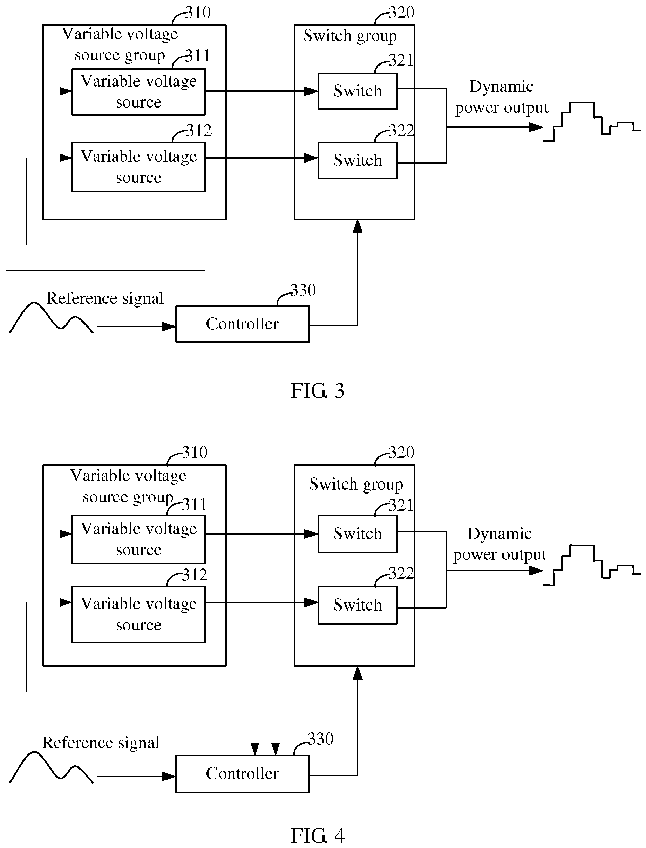

The following describes a variable voltage power supply provided in a second embodiment of the present invention in detail by using FIG. 3 as an example. FIG. 3 is a schematic structural diagram of a variable voltage power supply according to the second embodiment of the present invention. As shown in FIG. 3, the variable voltage power supply includes: a variable voltage source group 310, a switch group 320, and a controller 330.

The variable voltage source group 310 includes two variable voltage sources, a variable voltage source 311, and a variable voltage source 312. The switch group 320 includes two switches, a switch 321 and a switch 322. Each variable voltage source corresponds to one switch, that is, the variable voltage source 311 connects to the switch 321, and the variable voltage source 312 connects to the switch 322. The controllerconnects to the variable voltage source 311, the variable voltage source 312, and the switch group 320 respectively.

The variable voltage source group 310 is configured to supply a voltage. The controller 330 is configured to set a variable voltage source which outputs a voltage in the variable voltage source group 310 and a value of the output voltage, and control the switch group 320 to close a switch corresponding to the variable voltage source which is set to output the voltage, so that the set variable voltage source outputs the output voltage determined by the controller 330.

By applying variable voltage sources in the variable voltage power supply, the controller can control, according to a preset cycle and a strength of a reference signal, the variable voltage sources to output a voltage closest to the reference signal.

The following describes a working process of the variable voltage power supply provided in the second embodiment of the present in detail:
First, the controller 330 receives a reference signal. The controller 330 determines, in a first cycle, according to a strength of the received reference signal in a second cycle, an output voltage required for the variable voltage source group 320 in the second cycle.

The second cycle is any one cycle after the first cycle. The first cycle and the second cycle are relative. The first cycle may be a second cycle relative to a cycle before itself, and the second cycle may be a first cycle relative to a cycle after itself.

The embodiment describes the process by using an example that the first cycle is a current cycle, and the second cycle is a next cycle of the current cycle.

The reference signal is an envelope signal. A cycle length of the output voltage is set according to a bandwidth of the envelope signal and a quantity of variable voltage sources. In addition, a cycle of the output voltage corresponds to a cycle of the reference signal.

Because the cycle of the output voltage corresponds to the cycle of the reference signal, optionally, the controller 330 may calculate, according to, within the next cycle, a strengthof the reference signal which is received in the current cycle, a root mean square (Root Mean Square, RMS) value of the reference signal in the next cycle, and then determine, according to the RMS value, an output voltage required in the next cycle.

Then, the controller 330 sets, by outputting a pulse width modulation (Pulse Width Modulation, PWM) signal, the variable voltage source 311 or the variable voltage source 312 in the variable voltage source group 310 to output the required output voltage in the next cycle, and controls switches in the switch group 320 in the next cycle by outputting a source strobe signal. When the variable voltage source 311 is set to output the required output voltage in the next cycle, the controller 330 only controls the switch 321 to close in the next cycle. Similarly, when the variable voltage source 312 is set to output a voltage, the controller 330 only controls the switch 322 to close in the next cycle.

Specifically, when the variable power supplies are initially turned on, because no variable voltage source is outputting a voltage in the current cycle, the controller 330 may set any one variable voltage source of the variable voltage source group to output the required output voltage, and control the switch group 320 in the next cycle, so as to close the switch corresponding to the set variable voltage source, and open the other switch. For example, initially, the variable voltage source 311 is set to output a voltage, so the switch 321 is to be closed and the switch 322 is to be opened.

Within a cycle while the switch 321 is closed, that is, within a cycle when the variable voltage source 311 outputs the required output voltage, if a determined output voltage required for the variable voltage source group 310 in a next cycle equals the output voltage of the variable voltage source 311 in the current cycle, the controller 330 continues to set, in the current cycle, the variable voltage source 311 to output the required output voltage in the next cycle, and continues controlling the switch 321 to close and controlling the switch 322 to open in the next cycle, so as to control the variable voltage source 311 to continue outputting the same voltage in the next cycle as the output voltage in the current cycle.

Similarly, if the required output voltages, determined by the controller 330, of the variable voltage source group in the next cycle, cycle after the next cycle, and multiple continuous cycles, equal an output voltage in the current cycle, the variable voltage source which outputs the voltage in the current cycle is set to continue outputting the required output voltage, and the switch corresponding to the variable voltage source is controlled to close in a sustained manner. Such controlling manner can reduce switching actions of the switches, thereby reducing power consumption of the switches and decreasing fluctuation of the output voltage.

Within a cycle when the switch 321 is closed, that is, within a cycle when the variable voltage source 311 outputs a voltage, if a determined output voltage required for the variable voltage source group 310 in a next cycle differs from the output voltage of the variable voltage source 311 in the current cycle, the controller 330 sets, in the current cycle, the variable voltage source 312 to output the required output voltage in the next cycle, and controls the switch 322 to close and controls the switch 321 to open in the next cycle, so as to control the variable voltage source 312 to output the required output voltage in the next cycle. It should be noted that, when the variable voltage source is changed in the next cycle, because of a startup delay, it needs to set the variable voltage source 312 in the current cycle by using a PWM signal, so that the variable voltage source 312 can accurately output the required output voltage when the switch 322 is closed in the next cycle.

Similarly, if an output voltage, determined by the controller 330, required for the variable voltage source group in a cycle after the next cycle also differs from the output voltage in the next cycle, the two variable voltage sources are set to output a voltage alternately. Such controlling manner can avoid that a single variable voltage source cannot trace a reference signal effectively because of a low adjusting speed, thereby avoiding occurrence of a big tracing error.

In addition, FIG. 4 is a schematic structural diagram of another variable voltage power supply according to the second embodiment of the present invention. The controller 330 may also connects to an output end of the variable voltage source 311 and that of the variable voltage source 312 respectively, so as to receive voltage feedback signals fed back by the variable voltage source 311 and the variable voltage source 312. The voltage feedback signals include a value of an actual voltage outputted by the variable voltage group 310. The controller 330 adjusts, according to the voltage feedback signal fed back by each of the variable voltage sources, a related parameter of the variable voltage source group correspondingly.

Specifically, the actual output voltage value and the voltage value determined by the controller are compared, and a value of a PWM signal duty cycle is adjusted according to a comparison result, so that an error between the actual output voltage and the voltage set by the controller approaches zero.

It should be noted that the variable voltage power supply provided in the present invention is not limited to the variable voltage power supply provided in the second embodiment, where the variable voltage source group may include multiple variable voltage sources, and, correspondingly, the switch group may include multiple switches. If an output voltage that is required for the variable voltage source group in each cycle and determined by the controller 330 according to a strength of the reference signal in each cycle is different, the controller 330 sets multiple variable voltage sources to output the required output voltage alternately, and, correspondingly, controls, in each cycle, a switch corresponding to a variable voltage source which outputs the required output voltage to close, while controlling all other switches to open. When the variable voltage source group may include multiple variable voltage sources, the variable voltage source which is set to output the required output voltage may be one variable voltage source, or may also be a combination of multiple variable voltage sources.

In addition, the controller 330 may also determine, in the current cycle, according to a strength of the reference signal in any one cycle after the current cycle, an output voltage required for the variable voltage source group in any one cycle after the current cycle, and set a variable voltage source which outputs the required output voltage. It can be understood that, when a variable voltage source which outputs a voltage in any one cycle after the current cycle is set, it is set according to the output voltage required in a cycle preceding any one cycle after the current cycle and the variable voltage source which outputs the required output voltage.

By using the variable voltage power supply provided in the second embodimentof the present invention, by applying variable voltage sources in the variable voltage power supply, a controller determines, in a current cycle, according to a strength of a reference signal in any one cycle after the current cycle, an output voltage required in any one cycle after the current cycle, sets a variable voltage source which outputs the required output voltage in the variable voltage source group, and controls, in any one cycle after the current cycle, a switch corresponding to the variable voltage source which is set to output the required output voltage to close, so that a corresponding variable voltage source in the variable voltage source group outputs a voltage closest to the reference signal in any one cycle after the current cycle, thereby decreasing a tracing error. In addition, because the variable voltage power supply provided in a first embodiment of the present invention adopts variable voltage sources, where one variable voltage source can output voltage of different values, the quantity of variable voltage sources can be decreased and therefore costs can be decreased and a volume of the variable voltage power supply can be decreased.

A method for controlling an output voltage is provided in a third embodiment of the present invention, where the method is applied in the variable voltage power supply provided in a first embodiment of the present invention and an execution subject is a controller. The method for controlling an output voltage includes:
receiving a reference signal;
determining, in a first cycle, according to a strength of the reference signal in a second cycle, an output voltage required for a variable voltage source group in the second cycle, where the variable voltage source group includes at least two variable voltage sources, and each variable voltage source corresponds to one switch;
setting a variable voltage source which outputs the required output voltage in the second cycle; and
controlling, in the second cycle, a switch corresponding to the variable voltage source which outputs the required output voltage to close.

In a first possible implementation manner of the second aspect, the second cycle is any one cycle after the first cycle.

By using the method for controlling an output voltage provided in the third embodiment of the present invention, a controller can determine an output voltage required for a variable voltage source group, set a variable voltage source which outputs the required output voltage, and control a switch corresponding to the variable voltage source which is set to output the required output voltage to close, so that a corresponding variable voltage source in the variable voltage source group outputs a voltage closest to a reference signal, thereby decreasing a tracing error.

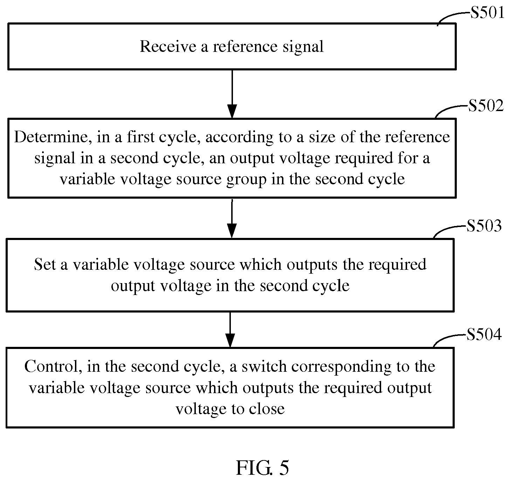

The following describes a method for controlling an output voltage provided in a fourth embodiment of the present invention in detail by using FIG. 5 as an example. FIG. 5 is a flowchart of a method for controlling an output voltage according to the fourth embodiment of the present invention. The method for controlling an output voltage is applied in a variable voltage power supply provided in the first embodiment or the second embodiment of the present invention, and an execution subject is a controller. As shown in FIG. 5, the method for controlling an output voltage includes the following steps:
Step S501: Receive a reference signal.

A reference signal from a baseband unit is received, so as to determine a value of an output voltage in each cycle.

The reference signal is an envelope signal. A cycle length of the output voltage is set according to a bandwidth of the envelope signal and a quantity of variable voltage sources. In addition, a cycle of the output voltage corresponds to a cycle of the reference signal. That is, the reference signal of a first cycle corresponds to the output voltage of the first cycle, the reference signal of a second cycle corresponds to the output voltage of the second cycle, and so on.

Step S502: Determine, in a first cycle, according to a strength of the reference signal in a second cycle, an output voltage required for a variable voltage source group in the second cycle.

The variable voltage source group includes at least two variable voltage sources, where each variable voltage source corresponds to one switch.

Optionally, the second cycle may be any one cycle after the first cycle. That is, the second cycle may be a cycle next to the first cycle, and may also be any one cycle after the first cycle. The first cycle and the second cycle are relative. The first cycle may be a second cycle relative to a cycle before itself, and the second cycle may be a first cycle relative to a cycle after itself.

Because the cycle of the output voltage corresponds to the cycle of the reference signal, it may calculate, according to, in the second cycle, a strength of the reference signal which is received in the first cycle, an RMS value of the reference signal in the second cycle, and then determine, according to the RMS value, the output voltage required in the second cycle.

Step S503: Set a variable voltage source which outputs the required output voltage in the second cycle.

The controller sets, by outputting a PWM signal, the variable voltage source which outputs the required output voltage.

Within the first cycle, after determining, according to a strength of the reference signal in the second cycle, an output voltage required for the variable voltage source group in the second cyclestrength, if the determined output voltage required for the variable voltage source group in the second cycle equals an output voltage of the variable voltage source group in an adjacent cycle before the second cycle, the controller sets a variable voltage source which outputs a voltage in the adjacent cycle before the second cycle to continue outputting the required output voltage in the second cycle.

Within the first cycle, after determining, according to a strength of the reference signal in the second cycle, an output voltage required for the variable voltage source group in the second cyclestrength, if the determined output voltage required for the variable voltage source group in the second cycle differs from the output voltage of the variable voltage source group in the adjacent cycle before the second cycle, the controller sets a variable voltage source which does not output a voltage in the adjacent cycle before the second cycle to output the required output voltage in the second cycle.

It should be noted that, when the variable power supplies are initially turned on, because no variable voltage source is outputting a voltage in the first cycle, the controller may set any one variable voltage source to output the required output voltage in a cycle next to the first cycle.

It should be noted that, because the variable voltage source group may include multiple variable voltage sources, the variable voltage source which is set to output the required output voltage may be one variable voltage source, or may also be a combination of multiple variable voltage sources. Optionally, a combination manner of multiple variable voltage sources may be connecting the multiple variable voltage sources in parallel.

Step S504: Control, in the second cycle, a switch corresponding to the variable voltage source which outputs the required output voltage to close.

The switch of each variable voltage source is controlled by outputting a source strobe signal.

Optionally, in the second cycle, a switch corresponding to the variable voltage source which does not output the required output voltage does not need to be controlled to open.

Optionally, the method for controlling an output voltage may further include the following steps: receiving voltage feedback signals fed back by the variable voltage sources, where the voltage feedback signals include a value of an actual voltage outputted by the variable voltage group; and adjusting, according to the voltage feedback signal fed back by each of the variable voltage sources, a related parameter of the variable voltage source group correspondingly.

Specifically, the actual output voltage value and the voltage value determined by the controller are compared, and a value of a PWM signal duty cycle is adjusted according to a comparison result, so that an error between the actual output voltage and the voltage set by the controller approaches zero.

By using the method for controlling an output voltage provided in the second embodiment of the present invention, a controller can determine, in a first cycle, according to a strength of a reference signal in a second cycle, an output voltage required in the second cycle, set a variable voltage source which outputs the required output voltage, and control, in the second cycle, a switch corresponding to the variable voltage source which is set to output the required output voltage to close, so that a corresponding variable voltage source in the variable voltage source group outputs a voltage closest to the reference signal in the second cycle, thereby decreasing a tracing error.

A person skilled in the art can be further aware that, the units and algorithm steps described in the examples with reference to the embodiments disclosed herein can be implemented by electronic hardware, computer software, or a combination thereof. To clearly describe the interchangeability between hardware and software, the foregoing has generally described compositions and steps in the examples based on functions. Whether the functions are performed by hardware or software depends on particular applications and design constraint conditions of the technical solution. A person skilled in the art may use a different method to implement the described functions for each particular application, but it should not be considered that such implementation goes beyond the scope of the present invention.

The steps of the methods or algorithms described with reference to the embodiments disclosed herein may be implemented by hardware, a software module executed by a processor, or a combination of the two. The software module may be placed in a random access memory (RAM), a memory, a read-only memory (ROM), an electrically programmable ROM, an electrically erasable programmable ROM, a register, a hard disk, a removable magnetic disk, a CD-ROM, or a storage medium of any other form commonly known in the art.

The objectives, technical solutions, and benefits of the present invention are further described in detail in the above specific embodiments, but it should be understood that the above described are merely specific embodiments of the present invention, and are not intended to limit the protection scope of the present invention.

## Claims

1. A variable voltage power supply, comprising a controller(230), a variable voltage source group(210), and a switch group(220); wherein:
the variable voltage source group(210) comprises at least two variable voltage sources(211), wherein the variable voltage source group(210) is configured to supply a voltage;
the switch group(220) comprises at least two switches(221), wherein each switch(221) connects to one variable voltage source(211), and the switch group(220) is configured to control whether the variable voltage sources(211) output a voltage; and
the controller(230) connects to each of the variable voltage sources(211) and the switch group(220), and is configured to receive a reference signal in a first cycle;
**characterized in that** the controller(230) is further configured to determine, according to a strength of the reference signal in a second cycle, an output voltage required for the variable voltage source group(210) in the second cycle, set a variable voltage source(211) which outputs the required output voltage for the variable voltage source group, and control, in the second cycle, a switch(221) of the switch group corresponding to the set variable voltage source which outputs the required output voltage to be closed, so as to control the variable voltage source (211) which is set to output the required output voltage to output a voltage;
wherein the second cycle is any one cycle after the first cycle.

2. The variable voltage power supply according to claim 1, wherein the setting a variable voltage source(211) which outputs the required output voltage is specifically as follows:
if the output voltage required for the variable voltage source group (210) in the second cycle equals an output voltage of the variable voltage source group(210) in an adjacent cycle before the second cycle, setting a variable voltage source(211) which outputs a voltage in the adjacent cycle before the second cycle to continue outputting the required output voltage in the second cycle.

3. The variable voltage power supply according to claim 1 or 2, wherein the setting a variable voltage source which outputs the required output voltage is specifically as follows:
if the output voltage required for the variable voltage source group(210) in the second cycle differs from an output voltage of the variable voltage source group(210) in an adjacent cycle before the second cycle, setting a variable voltage source(211) which does not output a voltage in the adjacent cycle before the second cycle to output the required output voltage in the second cycle.

4. The variable voltage power supply according to any one of claims 1 to 3, wherein the controller(230) is further configured to receive voltage feedback signals of the variable voltage sources(211), so as to adjust a pulse width modulation signal duty cycle of the variable voltage source group(210) according to the voltage feedback signals.

5. The variable voltage power supply according to any one of claims 1 to 4, wherein the controller(230) sets, by using a pulse width modulation signal, the variable voltage source(211) which outputs the required output voltage.

6. A method for controlling an output voltage, comprising:
receiving(S501) a reference signal;
**characterized by** further comprising
determining(S502), in a first cycle, according to a strength of the reference signal in a second cycle, an output voltage required for a variable voltage source group in the second cycle, wherein the variable voltage source group comprises at least two variable voltage sources, and each variable voltage source corresponds to one switch of a switch group;
setting(S503) a variable voltage source which outputs the required output voltage in the second cycle; and
controlling(S504), in the second cycle, a switch of the switch group corresponding to the set variable voltage source which outputs the required output voltage to close, so as to control the variable voltage source which is set to output the required output voltage to output a voltage;
wherein the second cycle is any one cycle after the first cycle.

7. The method according to claim 6, wherein the second cycle is any one cycle after the first cycle.

8. The method according to claim 6 or 7, wherein the setting a variable voltage source which outputs the required output voltage in the second cycle is specifically as follows:
if the output voltage required for the variable voltage source group in the second cycle equals an output voltage of the variable voltage source group in an adjacent cycle before the second cycle, setting a variable voltage source which outputs a voltage in the adjacent cycle before the second cycle to continue outputting the required output voltage in the second cycle.

9. The method according to claim 6 or 7, wherein the setting a variable voltage source which outputs the required output voltage in the second cycle is specifically as follows:
if the output voltage required for the variable voltage source group in the second cycle differs from an output voltage of the variable voltage source group in an adjacent cycle before the second cycle, setting a variable voltage source which does not output a voltage in the adjacent cycle before the second cycle to output the required output voltage in the second cycle.

10. The method according to any one of claims 6 to 9, further comprising:
receiving voltage feedback signals of the variable voltage sources, wherein the voltage feedback signals comprise a value of an actual output voltage of the variable voltage source group; and
adjusting a pulse width modulation signal duty cycle of the variable voltage source group according to the voltage feedback signals.

11. The method according to any one of claims 6 to 10, wherein the variable voltage source which outputs the required output voltage is set by using a pulse width modulation signal.

12. A computer-readable storage medium having a program stored thereon, the program comprising instructions for executing the method any of claims 6 to 11.

## Patentansprüche

1. Variable Spannungsstromversorgung, umfassend eine Steuerung(230), eine variable Spannungsquellengruppe(210) und eine Schaltergruppe(220); wobei:
die variable Spannungsquellengruppe(210) wenigstens zwei variable Spannungsquellen(211) umfasst, wobei die variable Spannungsquellengruppe(210) konfiguriert ist, um eine Spannung zuzuführen;
die Schaltergruppe(220) wenigstens zwei Schalter(221) umfasst, wobei jeder Schalter(221) sich mit einer variablen Spannungsquelle(211) verbindet und die Schaltergruppe(220) konfiguriert ist, um zu steuern, ob die variablen Spannungsquellen(211) eine Spannung ausgeben; und
die Steuerung(230) sich mit jeder der variablen Spannungsquellen(211) und der Schaltergruppe(220) verbindet und konfiguriert ist, um ein Bezugssignal in einer ersten Periode zu empfangen;
**dadurch gekennzeichnet, dass** die Steuerung(230) ferner konfiguriert ist, um gemäß einer Stärke des Bezugssignals in einer zweiten Periode eine Ausgangsspannung zu bestimmen, die für die variable Spannungsquellengruppe(210) in der zweiten Periode erforderlich ist, eine variable Spannungsquelle(211) einzustellen, die die erforderliche Ausgangsspannung für die variable Spannungsquellengruppe ausgibt, und in der zweiten Periode einen Schalter(221) der Schaltergruppe zu steuern, der der eingestellten variablen Spannungsquelle entspricht, die die erforderliche zu schließende Ausgangsspannung ausgibt, um die variable Spannungsquelle (211) zu steuern, die eingestellt ist, um die erforderliche Ausgangsspannung auszugeben, um eine Spannung auszugeben;
wobei die zweite Periode eine beliebige Periode nach der ersten Periode ist.

2. Variable Spannungsstromversorgung nach Anspruch 1, wobei das Einstellen einer variablen Spannungsquelle(211), die die erforderliche Ausgangsspannung ausgibt, speziell wie folgt ist:
wenn die Ausgangsspannung, die für die variable Spannungsquellengruppe (210) in der zweiten Periode erforderlich ist, gleich einer Ausgangsspannung der variablen Spannungsquellengruppe(210) in einer angrenzenden Periode vor der zweiten Periode ist, Einstellen einer variablen Spannungsquelle(211), die eine Spannung in der angrenzenden Periode vor der zweiten Periode ausgibt, um ein Ausgeben der erforderlichen Ausgangsspannung in der zweiten Periode fortzusetzen.

3. Variable Spannungsstromversorgung nach Anspruch 1 oder 2, wobei das Einstellen einer variablen Spannungsquelle, die die erforderliche Ausgangspannung ausgibt, speziell wie folgt ist:
wenn die Ausgangsspannung, die für die variable Spannungsquellengruppe(210) in der zweiten Periode erforderlich ist, sich von einer Ausgangsspannung der variablen Spannungsquellengruppe(210) in einer angrenzenden Periode vor der zweiten Periode unterscheidet, Einstellen einer variablen Spannungsquelle(211), die nicht eine Spannung in der angrenzenden Periode vor der zweiten Periode ausgibt, um die erforderliche Ausgangsspannung in der zweiten Periode auszugeben.

4. Variable Spannungsstromversorgung nach einem der Ansprüche 1 bis 3, wobei die Steuerung(230) ferner konfiguriert ist, um Spannungsrückkopplungssignale der variablen Spannungsquellen(211) zu empfangen, um einen Impulsbreitenmodulationssignaltastgrad der variablen Spannungsquellengruppe(210) gemäß der Spannungsrückkopplungssignale anzupassen.

5. Variable Spannungsstromversorgung nach einem der Ansprüche 1 bis 4, wobei die Steuerung(230) durch Verwenden eines Impulsbreitenmodulationssignals die variable Spannungsquelle(211) einstellt, die die erforderliche Ausgangsspannung ausgibt.

6. Verfahren zum Steuern einer Ausgangsspannung, Folgendes umfassend:
Empfangen(S501) eines Bezugssignals;
**gekennzeichnet dadurch, dass** es ferner Folgendes umfasst: Bestimmen(S502), in einer ersten Periode gemäß einer Stärke des Bezugssignals in einer zweiten Periode, einer Ausgangsspannung, die für eine variable Spannungsquellengruppe in der zweiten Periode erforderlich ist, wobei die variable Spannungsquellengruppe wenigstens zwei variable Spannungsquellen umfasst und jede variable Spannungsquelle einem Schalter einer Schaltergruppe entspricht;
Einstellen(S503) einer variablen Spannungsquelle, die die erforderliche Ausgangsspannung in der zweiten Periode ausgibt; und
Steuern(S504), in der zweiten Periode, eines Schalters der Schaltergruppe, der der eingestellten variablen Spannungsquelle entspricht, die die erforderliche Ausgangsspannung ausgibt, um sie zu schließen, um die variable Spannungsquelle zu steuern, die eingestellt ist, um die erforderliche Ausgangsspannung auszugeben, um eine Spannung auszugeben;
wobei die zweite Periode eine beliebige Periode nach der ersten Periode ist.

7. Verfahren nach Anspruch 6, wobei die zweite Periode eine beliebige Periode nach der ersten Periode ist.

8. Verfahren gemäß Anspruch 6 oder 7, wobei das Einstellen einer variablen Spannungsquelle, die die erforderliche Ausgangsspannung in der zweiten Periode ausgibt, speziell wie folgt ist:
wenn die Ausgangsspannung, die für die variable Spannungsquellengruppe in der zweiten Periode erforderlich ist, gleich einer Ausgangsspannung der variablen Spannungsquellengruppe in einer angrenzenden Periode vor der zweiten Periode ist, Einstellen einer variablen Spannungsquelle, die eine Spannung in der angrenzenden Periode vor der zweiten Periode ausgibt, um das Ausgeben der erforderlichen Ausgangsspannung in der zweiten Periode fortzusetzen.

9. Verfahren nach Anspruch 6 oder 7, wobei das Einstellen einer variablen Spannungsquelle, die die erforderliche Spannung in der zweiten Periode ausgibt, speziell wie folgt ist:
wenn sich die für die variable Spannungsquellengruppe in der zweiten Periode erforderliche Ausgangsspannung von einer Ausgangsspannung der variablen Spannungsquellengruppe in einer angrenzenden Periode vor der zweiten Periode unterscheidet, Einstellen einer variablen Spannungsquelle, die nicht eine Spannung in der angrenzenden Periode vor der zweiten Periode ausgibt, um die erforderliche Ausgangsspannung in der zweiten Periode auszugeben.

10. Verfahren nach einem der Ansprüche 6 bis 9, ferner Folgendes umfassend:
Empfangen von Spannungsrückkopplungssignalen der variablen Spannungsquellen, wobei die Spannungsrückkopplungssignale einen Wert einer tatsächlichen Ausgangsspannung der variablen Spannungsquellengruppe umfassen; und
Anpassen eines Impulsbreitenmodulationssignaltastgrads der variablen Spannungsquellengruppe gemäß den Spannungsrückkopplungssignalen.

11. Verfahren nach einem der Ansprüche 6 bis 10, wobei die variable Spannungsquelle, die die erforderliche Ausgangsspannung ausgibt, durch Verwenden eines Impulsbreitenmodulationssignals eingestellt wird.

12. Computerlesbares Speichermedium, das ein Programm darauf gespeichert aufweist, wobei das Programm Anweisung zum Ausführen des Verfahrens nach einem der Ansprüche 6 bis 11 umfasst.

## Revendications

1. Alimentation électrique à tension variable, comprenant un dispositif de commande (230), un groupe de sources de tension variable (210), et un groupe de commutateurs (220) ; dans laquelle :
le groupe de sources de tension variable (210) comprend au moins deux sources de tension variable (211), le groupe de sources de tension variable (210) étant configuré pour fournir une tension ;
le groupe de commutateurs (220) comprend au moins deux commutateurs (221), chaque commutateur (221) étant connecté à une source de tension variable (211), et le groupe de commutateurs (220) étant configuré pour commander si les sources de tension variable (211) émettent une tension ; et
le dispositif de commande (230) se connecte à chacune des sources de tension variable (211) et au groupe de commutateurs (220) et est configuré pour recevoir un signal de référence dans un premier cycle ;
**caractérisé en ce que** le dispositif de commande (230) est en outre configuré pour : déterminer, selon une intensité du signal de référence dans un second cycle, une tension de sortie requise pour le groupe de sources de tension variable (210) dans le second cycle, établir une source de tension variable (211) qui émet la tension de sortie requise pour le groupe de sources de tension variable et commander, dans le second cycle, un commutateur (221) du groupe de commutateurs correspondant à la source de tension variable établie qui émet la tension de sortie requise à fermer, afin de commander la source de tension variable (211) qui est établie pour émettre la tension de sortie requise pour émettre une tension ;
le second cycle étant un cycle quelconque après le premier cycle.

2. Alimentation électrique à tension variable selon la revendication 1, dans laquelle l'établissement d'une source de tension variable (211) qui émet la tension de sortie requise est spécifiquement comme suit :
si la tension de sortie requise pour le groupe de sources de tension variable (210) dans le second cycle est égale à une tension de sortie du groupe de sources de tension variable (210) dans un cycle adjacent avant le second cycle, établir une source de tension variable (211) qui émet une tension dans le cycle adjacent avant le second cycle pour continuer à émettre la tension de sortie requise dans le second cycle.

3. Alimentation électrique à tension variable selon la revendication 1 ou 2, dans laquelle l'établissement d'une source de tension variable qui émet la tension de sortie requise est spécifiquement comme suit :
si la tension de sortie requise pour le groupe de sources de tension variable (210) dans le second cycle diffère d'une tension de sortie du groupe de sources de tension variable (210) dans un cycle adjacent avant le second cycle, établir une source de tension variable (211) qui n'émet pas de tension dans le cycle adjacent avant le second cycle pour émettre la tension de sortie requise dans le second cycle.

4. Alimentation électrique à tension variable selon l'une quelconque des revendications 1 à 3, dans laquelle le dispositif de commande (230) est en outre configuré pour recevoir des signaux de rétroaction de tension des sources de tension variable (211), afin d'ajuster un facteur de marche de signal de modulation d'impulsions en largeur du groupe de sources de tension variable (210) selon les signaux de rétroaction de tension.

5. Alimentation électrique à tension variable selon l'une quelconque des revendications 1 à 4, dans laquelle le dispositif de commande (230) établit, à l'aide d'un signal de modulation d'impulsions en largeur, la source de tension variable (211) qui émet la tension de sortie requise.

6. Procédé pour commander une tension de sortie, consistant à :
recevoir (S501) un signal de référence ;
**caractérisé en ce qu'**il comprend en outre
la détermination (S502), dans un premier cycle, selon l'intensité du signal de référence dans un second cycle, d'une tension de sortie requise pour un groupe de sources de tension variable dans le second cycle, le groupe de sources de tension variable comprenant au moins deux sources de tension variable, et chaque source de tension variable correspondant à un commutateur d'un groupe de commutateurs ;
établir (S503) une source de tension variable qui émet la tension de sortie requise dans le second cycle ; et
commander (S504), dans le second cycle, un commutateur du groupe de commutateurs correspondant à la source de tension variable établie qui émet la tension de sortie requise à fermer, afin de commander la source de tension variable qui est établie pour émettre la tension de sortie requise pour émettre une tension ;
le second cycle étant un cycle quelconque après le premier cycle.

7. Procédé selon la revendication 6, dans lequel le second cycle est un cycle quelconque après le premier cycle.

8. Procédé selon la revendication 6 ou 7, dans lequel l'établissement d'une source de tension variable qui émet la tension de sortie requise dans le second cycle est spécifiquement comme suit :
si la tension de sortie requise pour le groupe de sources de tension variable dans le second cycle est égale à une tension de sortie du groupe de sources de tension variable dans un cycle adjacent avant le second cycle, établir une source de tension variable qui émet une tension dans le cycle adjacent avant le second cycle pour continuer à émettre la tension de sortie requise dans le second cycle.

9. Procédé selon la revendication 6 ou 7, dans lequel l'établissement d'une source de tension variable qui émet la tension de sortie requise dans le second cycle est spécifiquement comme suit :
si la tension de sortie requise pour le groupe de sources de tension variable dans le second cycle diffère d'une tension de sortie du groupe de sources de tension variable dans un cycle adjacent avant le second cycle, établir une source de tension variable qui n'émet pas de tension dans le cycle adjacent avant le second cycle pour émettre la tension de sortie requise dans le second cycle.

10. Procédé selon l'une quelconque des revendications 6 à 9, consistant en outre à :
recevoir des signaux de rétroaction de tension des sources de tension variable, les signaux de rétroaction de tension comprenant une valeur d'une tension de sortie réelle du groupe de sources de tension variable ; et
ajuster un facteur de marche de signal de modulation d'impulsions en largeur du groupe de sources de tension variable selon les signaux de rétroaction de tension.

11. Procédé selon l'une quelconque des revendications 6 à 10, dans lequel la source de tension variable qui émet la tension de sortie requise est établie à l'aide d'un signal de modulation d'impulsions en largeur.

12. Support de stockage lisible par ordinateur sur lequel est stocké un programme, le programme comprenant des instructions pour exécuter le procédé selon l'une quelconque des revendications 6 à 11.
